**Europäisches Patentamt**

**European Patent Office**

**Office européen des brevets**

(11) Veröffentlichungsnummer: **0 157 084**
**A1**

(12) **EUROPÄISCHE PATENTANMELDUNG**

(21) Anmeldenummer: **85100497.8**

(22) Anmeldetag: **18.01.85**

(51) Int. Cl.⁴: **G 01 R 31/28**

(30) Priorität: **03.04.84 DE 3412850**

(43) Veröffentlichungstag der Anmeldung: **09.10.85**
**Patentblatt 85/41**

(84) Benannte Vertragsstaaten: **AT DE FR GB NL SE**

(71) Anmelder: **ROBERT BOSCH GMBH, Postfach 50,**
**D-7000 Stuttgart 1 (DE)**

(72) Erfinder: **Müller, Klaus-Dieter, Dipl. Ing., Eislebener**
**Strasse 5, D-1000 Berlin 30 (DE)**

(74) Vertreter: **Schmidt, Hans-Ekhardt, Robert Bosch GmbH**
**Geschäftsbereich Elektronik Patent- und**
**Lizenzabteilung Forckenbeckstrasse 9-13,**
**D-1000 Berlin 33 (DE)**

(54) Prüfverfahren für ein mikroprozessorgesteuertes elektronisches Gerät.

(57) Es wird ein Prüfverfahren für ein mikroprozessorgesteuertes elektronisches Gerät vorgeschlagen, bei dem zur Prüfung einzelner Gerätefunktionen die vorhandenen Tasten der Tastatur, das Display sowie die Mikroprozessoreinheit mitausgenutzt werden. Das Prüfverfahren besteht darin, daß beim Betätigen mindestens einer Taste (13) vor und während des Einschaltens des Gerätes mit dem Ein/Ausschalter (17) die Mikroprozessoreinheit (22) auf einen Prüfmodus vorbereitet wird. Anschließend wird mittels der Tastatur ein bestimmtes Kodewort eingegeben, das einem bestimmten Prüfprogramm von mehreren Prüfprogrammen entspricht. Das Gewählte Prüfprogramm wird auf dem Display (16) angezeigt. Es folgt das Betätigen einer Starttaste (15), das ist eine vorhandene Taste, die durch die Vorbereitung auf den Prüfmodus die Startfunktion übernimmt. Mit dem Betätigen der Starttaste wird das dem gewählten Kodewort entsprechende Prüfprogramm abgerufen und ausgeführt. Das Prüfergebnis wird auf dem Display angezeigt.

12/84
EK/PLI Scht-Li
3.4.1984

ROBERT BOSCH GMBH, 7000 Stuttgart 1

Prüfverfahren für ein mikroprozessorgesteuertes elektronisches Gerät

## Stand der Technik

Die Erfindung geht von einem mikroprozessorgesteuerten elektronischen
Gerät nach der im Oberbegriff des Anspruchs 1 angegebenen Gattung aus.

Derartige Geräte, dazu gehören beispielsweise Sprechfunkgeräte, sind
bekannt (NTZ, 1983, Heft 6, Seite 401). Sollen einzelne elektrische
Funktionen eines derartigen Gerätes geprüft werden, so ist es in der
Regel erforderlich, die Geräteschaltung und die Mikroprozessoreinheit
über einen an der Außenseite des Gerätegehäuses vorhandenen Steckverbinder mit einer aufwendigen Prüfeinrichtung zu verbinden.

## Vorteile der Erfindung

Das erfindungsgemäße mikroprozessorgesteuerte elektronische Gerät mit
den kennzeichnenden Merkmalen des Anspruchs 1 hat den Vorteil, daß zur
Prüfung einzelner Gerätefunktionen vorhandene Tasten der Tastatur, das
Display des Gerätes sowie die Mikroprozessoreinheit mitausgenutzt werden
können und daß auf eine komplizierte Prüfeinrichtung verzichtet werden
kann. Weiterhin können auch in der Mikroprozessoreinheit gespeicherte
gerätespezifische technische Daten abgerufen und auf dem Display des
Gerätes angezeigt werden. Darüber hinaus wird durch die besondere Art
der Tasten- und Schalterbetätigung im Falle einer Prüfung ein versehentliches oder unbefugtes Auslösen des Prüfprogrammablaufs verhindert.

...

Besonders vorteilhaft ist ein erfindungsgemäßes mikroprozessorgesteuertes
elektronisches Gerät, bei dem das Prüfergebnis mittels einer an die Geräteschaltung angeschlossenen Prüfvorrichtung in Verbindung mit der Mikroprozessoreinheit ermittelt und mit der Prüfvorrichtung angezeigt wird. Ein
derartiges Gerät hat den Vorteil, daß für die Prüfung vergleichsweise einfache Prüfmittel eingesetzt werden können.


## Zeichnung

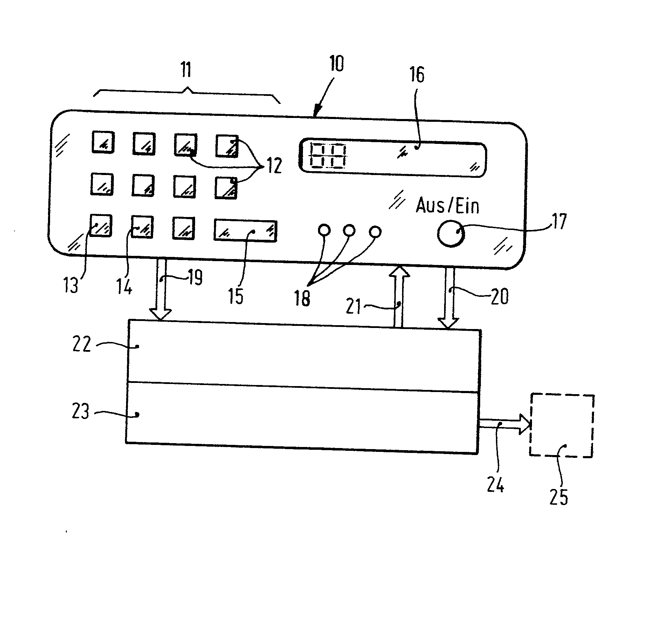

Ein Ausführungsbeispiel der Erfindung ist in der Zeichnung an Hand einer
einzigen Figur dargestellt und in der nachfolgenden Beschreibung näher
erläutert.


## Beschreibung der Erfindung

Nach dem in der einzigen Figur gezeigten stark vereinfachten Blockschaltbild
eines erfindungsgemäßen mikroprozessorgesteuerten Funkgeräte-Bedienteils bezeichnet 10 die Frontplatte des Bedienteils. Auf dieser Frontplatte befinden
sich eine zum Beispiel alphanumerische Tastatur 11 mit Drucktasten 12 bis 15,
ein Display 16, das ist zum Beispiel eine Flüssigkristallanzeige, und ein
Ein/Ausschalter 17 für das Gerät sowie weitere Bedienungs- und Anzeigeelemente 18. Das Gerät enthält eine mit der Tastatur 11, dem Ein/Ausschalter 17 und dem Display 16 über Leitungen 19, 20, 21 verbundene Mikroprozessoreinheit 22. Die Mikroprozessoreinheit bildet zusammen mit einer Geräteschaltung 23 den elektrischen Teil des Funkgeräte-Bedienteils. Über Leitungen 24
kann eine Prüfvorrichtung 25 von der Außenseite des Gerätes her mit der
Geräteschaltung verbunden werden.

Das vorstehend beschriebene Funkgeräte-Bedienteil funktioniert folgendermaßen.
Mit der Tastatur 11 kann der Benutzer des Bedienteils über die Mikroprozessoreinheit 22 die üblichen Funktionen, wie zum Beispiel Kanalwahl, Kennungsgabe
und dergleichen, einleiten. Diese Funktionen können auf dem Display 16 sichtbar gemacht werden. Auf eine genaue Beschreibung dieser Funktionsabläufe wird
verzichtet, weil sie dem Fachmann bekannt sind.

...

Bei dem vorliegenden Funkgeräte-Bedienteil kann nun eine Prüfung einzelner Gerätefunktionen auf folgende Weise vorgenommen werden. Nur wenn beispielsweise eine Taste, zum Beispiel die Taste 13, oder mehrere Tasten, zum Beispiel die beiden nebeneinanderliegenden Tasten 13 und 14, der Tastatur 11 gleichzeitig betätigt werden und wenn bei betätigter Taste bzw. bei betätigten Tasten zusätzlich das Gerät mit dem Ein/Ausschalter 17 eingeschaltet wird, wird die Mikroprozessoreinheit 22 auf einen Prüfmodus vorbereitet. In diesem Zustand können noch alle Funktionen des Bedienteils ausgelöst bzw. durchgeführt werden. Ist die Mikroprozessoreinheit auf den Prüfmodus vorbereitet, so kann der Benutzer nunmehr mittels der Tastatur 11 ein Kodewort aus einer Vielzahl von Kodewörtern eingeben. Jedes Kodewort entspricht einem bestimmten in der Mikroprozessoreinheit gespeicherten Prüfprogramm. Das in die Tastatur eingegebene Kodewort bzw. das diesem entsprechende Prüfprogramm wird dann mittels des Displays 16 angezeigt. Der nächste Schritt ist das Betätigen einer Starttaste, zum Beispiel 15. Die Starttaste ist eine der ohnehin vorhandenen Tasten der Tastatur. Diese Taste wird zur Starttaste, wenn die Mikroprozessoreinheit auf den Prüfmodus vorbereitet wird. Mit dem Betätigen der Starttaste wird das dem eingegebenen Kodewort entsprechende Prüfprogramm abgerufen, zum Beispiel ein Prüfprogramm, mit dem ein bestimmter Ton einer Mehrtonfolge eines zu dem Bedienteil gehörenden Selektivrufgebers ausgelöst und geprüft wird. Das Ergebnis der Prüfung wird auf dem Display angezeigt. Auf dem Display kann beispielsweise auch ein Meßwert - bei einem Ton zum Beispiel die Frequenz oder der Pegel - angezeigt werden. Prüfung und Anzeige können gegebenenfalls auch mit der an das Bedienteil anzuschließenden externen Prüfvorrichtung 25 erfolgen. Diese Prüfvorrichtung besteht im Gegensatz zu den bekannten Spezialvorrichtungen aus einfachen Meßgeräten.

12/84
EK/PLI Sch-Li
3.4.1984

ROBERT BOSCH GMBH, 7000 Stuttgart 1

Ansprüche

1. Prüfverfahren für ein mikroprozessorgesteuertes elektronisches Gerät mit einer Mikroprozessoreinheit, mit der eine Geräteschaltung, eine Tastatur und ein Ein/Ausschalter für das Gerät verbunden sind, dadurch gekennzeichnet,

   a) daß beim Betätigen mindestens einer Taste (13) der vorhandenen Tasten der Tastatur (11) vor und während des Einschaltens des Gerätes mit dem Ein/Ausschalter (17) die Mikroprozessoreinheit (22) auf einen die normalen Gerätefunktionen nicht beeinflussenden Prüfmodus vorbereitet wird,

   b) daß anschließend mittels der Tastatur (11) ein bestimmtes Kodewort eingegeben wird, welches aus einer Vielzahl von Kodewörtern ausgewählt wird, die je einem in der Mikroprozessoreinheit (22) gespeicherten Prüfprogramm für bestimmte Funktionen der Geräteschaltung entsprechen, und daß das gewählte Kodewort bzw. Prüfprogramm auf dem Display (16) des Gerätes angezeigt wird,

   c) daß durch das Betätigen einer Starttaste (15), die dadurch gebildet wird, daß eine der vorhandenen Tasten durch die Vorbereitung auf den Prüfmodus die Startfunktion übernimmt, das dem gewählten Kodewort entsprechende Prüfprogramm abgerufen und ausgeführt wird und

   d) daß das Prüfergebnis auf dem Display (16) angezeigt wird.

2. Prüfverfahren nach Anspruch 1, dadurch gekennzeichnet, daß das Prüfergebnis mittels einer an die Geräteschaltung (23) angeschlossenen Prüfvorrichtung (25) in Verbindung mit der Mikroprozessoreinheit (22) ermittelt und mit der Prüfvorrichtung angezeigt wird.

0157084

Aus/Ein

Europäisches
Patentamt

**EUROPÄISCHER RECHERCHENBERICHT**

0157084
Nummer der Anmeldung

EP 85 10 0497

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-2 805 104 (LOEWE OPTA)<br>* Ganzes Dokument * | 1,2 | G 01 R 31/28 |
| X | HEWLETT-PACKARD JOURNAL, Band 33, Nr. 4, April 1982, Amstelveen, NL; R.J. ROBERTS "An integrated test set for microwave radio link baseband analysis", Seiten 3-7<br>* Seite 7 "Reliability and Self Test" * | 1 | |

RECHERCHIERTE SACHGEBIETE (Int. Cl.4)

G 01 R 31/00
G 01 R 31/28

Der vorliegende Recherchenbericht wurde für alle Patentansprüche erstellt.

| Recherchenort<br>BERLIN | Abschlußdatum der Recherche<br>14-06-1985 | Prüfer<br>LEMMERICH J |
|---|---|---|